# EUROPÄISCHE PATENTANMELDUNG

(11) **EP 1 150 242 A2**
(43) Veröffentlichungstag der Anmeldung: **31.10.2001**
(21) Anmeldenummer: 01110498.1
(22) Anmeldetag: 27.04.2001
(51) Int. Cl.: G06K 11/18, H04M 1/02

(54) **Drehgeber für Bedieneingaben**

(30) Priorität: 27.04.2000 DE 10020687
(71) Anmelder: SIEMENS AKTIENGESELLSCHAFT, 80333 München (DE)
(72) Erfinder: Bock, Gerhard, 82152 Krailling (DE); Hrach, Michael, 81379 München (DE)

(57) **Zusammenfassung**

Die Erfindung betrifft eine Bedienoberfläche mit einem drehbaren Positionsgeber (DR, DW), insbesondere für ein Mobilfunkgerät (MF). Erfindungsgemäß ist der Positionsgeber (DR, DW) im Gehäuse des Gerätes geführt, und der Positionsgeber (DR, DW) ist drahtlos an eine Auswertestufe (RL) im Inneren des Gerätes zur Auswertung der Position und/oder der Drehbewegung des Positionsgebers (DR, DW) gekoppelt .

## Beschreibung

Die Erfindung betrifft eine Bedienoberfläche mit einem drehbaren Positionsgeber gemäß dem Oberbegriff des Patentanspruchs 1.

Solche Bedienoberflächen werden beispielsweise bei Endgeräten der Kommunikationstechnik und besonders bei Mobilfunkgeräten eingesetzt. Bedienoberflächen mit einem drehbaren Positionsgeber finden aber auch in Automobilen und in Lastkraftwagen Verwendung, dort beispielsweise zur Steuerung von Navigationseinrichtungen, zur Steuerung eines GPS-Empfängers (Global Positioning System), eines Autoradios oder auch zur Spiegelverstellung. Im Folgenden wird näher auf die Verwendung bei Kommunikationsendgeräten eingegangen.

Moderne Kommunikationsendgerät haben eine mehr und mehr komplexe Bedienoberfläche. Dies gilt insbesondere für zukünftige mobile Endgeräte mit Datenfunktionen, d.h. Mobilfunkgerät beziehungsweise Handys die neben der Audio- und bedarfsweise Videoübertragung auch zur Datenübertragung und zum Anschluß ans Internet ausgebildet sein können. Aus der Unterhaltungsindustrie sind sogenannte "jog-dials" bekannt, bei denen eine Scheibe beziehungsweise ein Drehknopf oder auch ein Drehring als Eingabeelement verwendet wird. Auch der Einsatz in mobilen Endgeräten wäre vorteilhaft, hier ist es aber besonders wichtig, sehr kleine und leichte Elemente zu verwenden.

Bekannte Drehgeber sind im inneren der Geräte angeordnet, und sind durch eine Achse mit einem Bedienelement auf der Außenseite des Gerätes verbunden. Dies hat den Nachteil, dass im Geräteinneren Volumen verbraucht wird, und zudem wird das Gewicht spürbar erhöht. Drehgeber als Komplettmodule sind zudem kostenintensiv. Durch die Achsdurchführungen entstehen auch zusätzliche Probleme mit der ESD-Festigkeit (Electro Static Discharge), sowie Probleme mit der Staubdichtigkeit und dem Eindringen von Feuchtigkeit.

Der Erfindung liegt die Aufgabe zugrunde, eine Bedienoberfläche mit einem drehbaren Positionsgeber anzugeben, der aus kleinen und leichten Elementen aufgebaut ist.

Diese Aufgabe wird erfindungsgemäß durch die im Patentanspruch 1 angegebenen Merkmale gelöst.

Die erfindungsgemäße Bedienoberfläche mit einem drehbaren Positionsgeber ist besonders vorteilhaft bei Mobilfunkgeräten einsetzbar. Im Inneren des Mobilfunkgerätes wird praktisch kein Volumen verbraucht, und der Positionsgeber selbst erhöht das Gewicht des Gerätes nur unwesentlich.

Im Folgenden wird die Erfindung anhand eines in der Zeichnung dargestellten Ausführungsbeispieles beschrieben. Dabei zeigen
Figur 1 eine Prinzipdarstellung einer Bedienoberfläche eines Mobilfunkgerätes sowie einen Schnitt durch die Gehäuseoberfläche,
Figur 2 eine Weiterbildung die in Figur 1 dargestellten Bedienoberfläche und
Figur 3 ein Mobilfunkgerät mit einer Drehwalze zur Bedieneingabe.

Die erfindungsgemäße Bedienoberfläche weist einen Drehgeber auf, der aus einer mechanischen Komponente auf der Geräteaussenseite und einer elektrischen Komponente im Geräteinneren besteht. Diese beiden Komponenten sind nicht mechanisch und nicht mit elektrischen Leitungen miteinander verbunden.

Bei einer möglichen Verwendung in einem Auto ist der mechanische Drehgeber beispielsweise im Cockpit oder in der Armlehne angebracht, während die Auswertestufe mechanisch getrennt in der Nähe angeordnet ist.

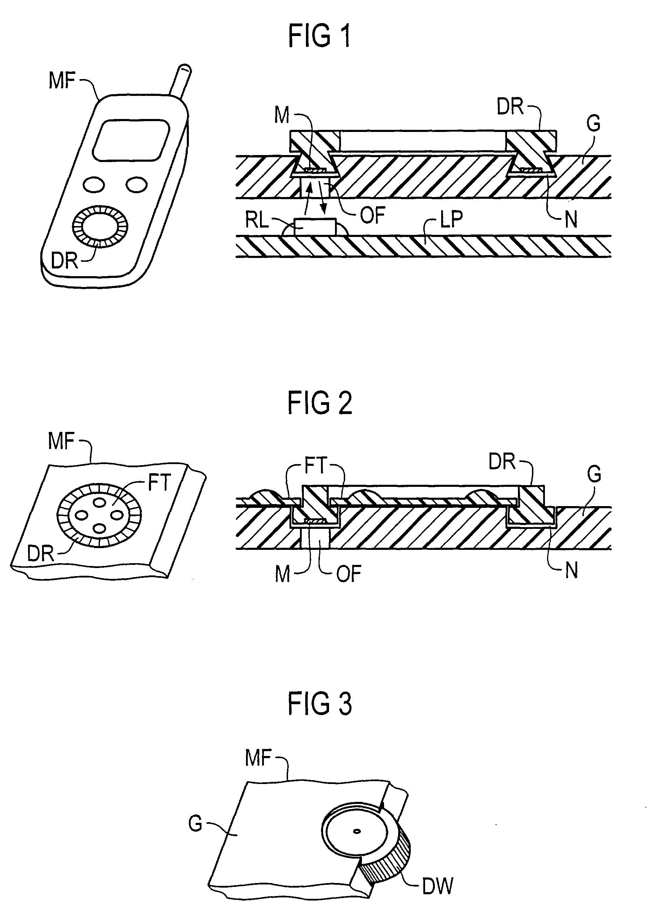

Figur 1 zeigt ein Mobilfunkgerät MF mit einer Prinzipdarstellung einer Bedienoberfläche, die nicht näher bezeichnete Tasten und eine Anzeigeeinrichtung aufweist. Daneben weist die Bedienoberfläche einen Drehring DR auf, dessen Befestigung und Funktion anhand der Schnittdarstellung näher erläutert wird.

Der Schnitt läuft durch ein Gehäuse G des Mobilfunkgerätes MF im Bereich des Drehgebers beziehungsweise des Drehringes DR. Der Drehring DR ist auf der Aussenseite des Gehäuses G angeordnet, und läuft mechanisch in einer ringförmigen Nut N. Die Nut N ist beispielsweise derart ausgeformt, so daß der Drehring DR in dieser Nut N beispielsweise formschlüssig, aber mit Spiel einschnappbar ist. Bei entsprechender Materialwahl, beispielsweise bei Verwendung von Teflon, läßt sich der Ring DR leicht drehen. An der zum Gehäuseinneren weisenden Seite weist der Drehring DR Markierungen M auf. Die Markierungen M bestehen beispielsweise aus einer abwechselnden Folge von schwarzen und weißen Strichen.

Im Geräteinneren ist auf einer Leiterplatte LP eine Reflexlichtschranke RL angeordnet. Durch eine Öffnung OF beziehungsweise ein Fenster im Bereich der Nut N des Gehäuses G können die Markierungen M am Drehring DR durch die Reflexlichtschranke RL abgetastet werden. Die Reflexlichtschranke RL bildet sozusagen eine Auswertestufe oder einen Sensor, durch die durch das Sichtfenster OF das Schwarz-Weiß-Muster auf der Rückseite des Drehringes ausgewertet wird. So lassen sich Drehwinkel und auch Drehrichtung bei einer Bewegung des Drehringes DR erkennen und in Steuersignale umsetzen. Diese weitere Signalverarbeitung ist für die Erfindung von untergeordneter Bedeutung und in der Figur nicht näher dargestellt.

Anstelle einer optischen Auswertung können auch andere drahtlose Techniken verwendet werden. So z.B. Magnetfeldsensoren, bei der im Drehring DR Magnetpole angeordnet werden. Die optischen oder magnetischen Sensoren sind in vorteilhafter Weise direkt auf die im Endgeräteinneren liegenden Leiterplatte LP aufgelötet, so dass jeglicher Zusatzaufwand entfällt. Hierdurch sind die Herstellkosten gering, es wird im Geräteinneren praktisch kein Volumen verbraucht. Durch die Vermeidung einer mechanischen Verbindung zwischen dem aussenliegenden mechanischen Element, dem Drehring DR, und der Auswertestufe RL im Inneren des Gehäuses G stellen die ESD-Festigkeit, die Staubdichtheit und sogar die Wasserdichtheit kein Problem dar.

Figur 2 zeigt eine Weiterbildung der Erfindung. Hierbei sind innerhalb des Drehringes DR Folientasten FT angeordnet, die beispielsweise konventionell direkt auf der Gehäuseaussenseite aufgeklebt sind. In diesem Fall muß der Drehring DR nicht in der Nut N eingeschnappt sein, sondern er wird einfach durch die Folientastatur FT gehalten. Bei der entsprechenden Ausgestaltung der Folientastatur FT kann auf die Nut N auch unter Umständen gänzlich verzichtet werden.

Bei einer weiteren Ausführung kann der Drehring DR auch mit einem Rastmechanismus versehen sein. Hierbei weisen beispielsweise zueinander weisende Flächen der Nut N und des Drehringes DR eine zackenartige oder wellenförmige Ausgestaltung auf.

In Figur 3 ist eine alternative Ausgestaltung des Drehringes DR dargestellt. Hierbei ist der Drehgeber DR beispielsweise bei einem Mobilfunkgerät MF durch eine Drehwalze DW realisiert beziehungsweise ersetzt. Die Drehwalze DW wird durch eine entsprechende Form des Gehäuses G an ihrer Oberfläche umfaßt und dort gehalten. Nicht dargestellt sind hier mögliche Öffnungen zum Geräteinneren, durch die eine optische Auswertung der Drehbewegung- und/oder der Drehposition möglich ist.

Auch hier ist statt einer optischen Auswertung eine allgemeine drahtlose Auswertetechnik einsetzbar.

## Patentansprüche

1. Bedienoberfläche mit einem drehbaren Positionsgeber (DR, DW), insbesondere für ein Mobilfunkgerät (MF),
**dadurch gekennzeichnet, dass**
der Positionsgeber (DR, DW) im Gehäuse des Gerätes geführt ist, und
der Positionsgeber (DR, DW) drahtlos an eine Auswertestufe (RL) im Inneren des Gerätes zur Auswertung der Position und/oder der Drehbewegung des Positionsgebers (DR, DW) gekoppelt ist.

2. Bedienoberfläche nach Anspruch 1,
**dadurch gekennzeichnet, dass**
der Positionsgeber (DR, DW) optisch lesbare Markierungen (M) aufweist, die durch ein Fenster (OF) im Gehäuse von einer optischen Auswertestufe (RL) auswertbar sind.
